# EUROPEAN PATENT APPLICATION

(11) **EP 3 564 316 A1**
(43) Date of publication of application: **06.11.2019**
(21) Application number: 17886959.0
(22) Date of filing: 15.05.2017
(51) Int. Cl.: C08L 71/12, C08L 63/00, C08L 79/04, C08K 5/03, H05K 1/03, C08J 5/24, B32B 15/14

(54) **FLAME-RETARDANT POLYPHENYLENE ETHER RESIN COMPOSITION**

(30) Priority: 28.12.2016 CN 201611232814
(71) Applicant: Shengyi Technology Co., Ltd., Dongguan City, Guangdong 523808 (CN)
(72) Inventor: MENG, Yundong, Dongguan Guangdong 523808 (CN); FANG, Kehong, Dongguan Guangdong 523808 (CN); XU, Ying, Dongguan Guangdong 523808 (CN)
(74) Representative: Plougmann Vingtoft a/s
(86) International application number: PCT/CN2017/084318
(87) International publication number: WO 2018/120590

(57) **Abstract**

The present invention relates to a flame-retardant polyphenylene ether resin composition, comprising, by weight percent: (A) 10-45% of a phosphorus-containing polyphenylene ether resin with a number-average molecular weight of 1000-6000; (B) 10-50% of an epoxy resin composition; (C) 10-50% of a cyanate ester resin; and (D) 10-30% of a soluble halogen flame retardant. The present invention adopts a phosphorus-containing polyphenylene ether resin with a low molecular weight that, when used in combination with an epoxy resin, a cyanate ester, and the like, improves the compatibility of the system and reduces a phase separation area of the system, and increases the adhesive force of a plate and enhances the toughness of the plate. The present invention adopts a soluble halogen flame retardant to further enhance the homogeneity of the resin system, and provides better uniformity, increased adhesion, and a lower dielectric constant and dielectric loss of the plate.

## Description

### Technical Field

The present invention relates to the technical field of copper clad laminates, and in particular to a flame-retardant polyphenylene ether resin composition and a prepreg and a copper clad laminate using the same.

### Background

Polyphenylene ether resin has good heat resistance, dielectric properties and toughness, and thus it has a good application prospect in composite materials such as laminates. However, due to the difference in polarity between polyphenylene ether and conventional thermosetting resins and the poor compatibility and that phase separation is easy to occur, resin phase separation is generally occurred in copper clad laminates of thermosetting resin systems such as polyphenylene ether-modified epoxy resin and cyanate ester, *etc.,* resulting in that the material is unevenly stressed when heated and is prone to problems such as popcorn during high temperature processing. Therefore, the application of polyphenylene ether has various difficulties.

Commonly used methods for improving compatibility are generally to reduce the molecular weight of polyphenylene ether resin to enhance its compatibility, or to insert a reactive group into the structure of a low-molecular-weight polyphenylene ether to enhance the connection between polyphenylene ether and other resins, or to introduce a compatibilizer into the polyphenylene ether resin composition to promote the compatibility between polyphenylene ether and other resins.

CN101796132A refers to a resin composition composed of a polyphenylene ether, an epoxy resin, a cyanate ester and a halogen flame retardant, *etc*., wherein the halogen flame retardant is ethylene dipentabromobenzene, ethylene bis(tetrabromophthalimide), decabromodiphenyl oxide, tetradecabromodiphenoxy benzene and bis(tribromophenoxy)ethane, *etc.* In this composition, the polyphenylene ether has poor compatibility with the epoxy resin and the cyanate ester, and phase separation or the like is easy to occur in the resin of the laminate. The flame retardant described above can satisfy flame retardancy requirements for the resin composition in a circuit substrate, but does not contribute to the compatibility between the polyphenylene ether and other component resins.

CN103842397A discloses a resin composition comprising a bifunctional phenylene ether oligomer having a polyphenylene ether skeleton, an aralkyl-based cyanate ester compound, a bisphenol-based cyanate ester compound, an epoxy resin, a brominated carbonate oligomer, an inorganic filler, an alkoxynaphthol-based polymerization inhibitor and/or a thioether-based polymerization inhibitor. A polyphenylene ether having a functional group is used in the composition. However, this kind of polyphenylene ether does not react with an epoxy resin or the like. Moreover, the bifunctionality cannot improve the compatibility between the polyphenylene ether and other components. The toughness of the laminate is relatively poor.

Therefore, how to improve the compatibility between polyphenylene ether and other components and maintain excellent comprehensive properties of copper clad laminates has become the focus of current research.

### Summary of the Invention

Based on the above, one of the objects of the present invention is to provide a polyphenylene ether resin composition which can not only effectively improve the compatibility between polyphenylene ether and epoxy resin, but also satisfy the flame retardancy requirement and reduce dielectric constant (Dk) and dielectric loss (Df).

In order to achieve the above object, the inventors have performed repeated and intensive studies, and found that by using a phosphorus-containing polyphenylene ether resin with a low molecular weight in combination with an epoxy resin and a cyanate ester, *etc*., the compatibility of the system is unexpectedly improved, the phase separation region thereof is reduced and the adhesion force and toughness of the laminate are enhanced. The use of a soluble halogen flame retardant further enhances the uniformity of the resin system. The laminate has good uniformity, enhanced adhesiveness and lower dielectric constant and dielectric loss.

In order to achieve the above object, the present invention adopts the following technical solutions:
A resin composition, comprising, by weight percentage:
(A) 10% to 45% of a phosphorus-containing polyphenylene ether resin having a number average molecular weight of 1000 to 6000;
(B) 10% to 50% of an epoxy resin composition;
(C) 10% to 50% of a cyanate ester resin;
(D) 10% to 30% of a soluble halogen flame retardant.

Wherein the percentage contents of components (A), (B), (C) and (D) exclude solvent.

In the present invention, by using a phosphorus-containing polyphenylene ether resin with a low molecular weight in combination with an epoxy resin and a cyanate ester, *etc*., the compatibility of the system is effectively improved, the phase separation region thereof is reduced and the adhesion force and toughness of the laminate are enhanced. Meanwhile, the use of a soluble halogen flame retardant further enhances the uniformity of the resin system. The laminate has good uniformity, enhanced adhesiveness and lower dielectric constant and dielectric loss.

According to the present invention, based on the total amount of (A), (B), (C) and (D), the weight percentage of the phosphorus-containing polyphenylene ether resin is 10% to 45%, for example 10%, 12%, 14%, 15%, 16%, 18%, 19%, 20%, 22%, 25%, 28%, 30%, 35%, 38%, 40%, 42% or 45%, as well as specific point values between the above values. The specific point values included within the range are no longer listed exhaustively herein due to the limitation of space and for concise considerations.

The phosphorus-containing polyphenylene ether resin of the present invention is a phosphorus-containing polyphenylene ether resin with a low molecular weight, whose number average molecular weight is controlled within the range of 1000-6000, for example, 1000, 1200, 1500, 1800, 2000, 2500, 3000, 3500, 4000, 4500, 5000, 5500 or 6000, as well as specific point values between the above values. The specific point values included within the range are no longer listed exhaustively herein due to the limitation of space and for concise considerations.

In the present invention, the phosphorus-containing polyphenylene ether resin is synthesized from a phosphorus-containing phenolic compound and a polyphenylene ether. In particular, it is a phosphorus-containing polyphenylene ether resin having a number average molecular weight of 1000 to 6000 which is obtained by subjecting a raw material of polyphenylene ether having a number average molecular weight of 2000-40000 and a phosphorus-containing phenolic compound which is suspended in the solution of the polyphenylene ether to a redistribution reaction in the presence of an initiator.

Wherein, based on 100 parts by weight of the raw material of polyphenylene ether, the phosphorus-containing phenolic compound is used in an amount of 4 to 50 parts, for example, 4 parts, 5 parts, 6 parts, 8 parts, 9 parts, 10 parts, 12 parts, 15 parts, 18 parts, 20 parts, 25 parts, 30 parts, 35 parts, 40 parts, 45 parts, 48 parts or 50 parts, as well as specific point values between the above values. The specific point values included within the range are no longer listed exhaustively herein due to the limitation of space and for concise considerations.

Preferably, the phosphorus-containing phenolic compound is a derivative of 9,10-dihydro-9-oxa-10-phosphaphenanthrene-10-oxide containing one or more phenolic hydroxyl groups; preferably contains any one selected from the group consisting of the adducts of 9,10-dihydro-9-oxa-10-phosphaphenanthrene-10-oxide and, respectively, benzoquinone, 1,4-naphthoquinone, *p*-hydroxyphenyl maleimide and rosolic acid, and a combination of at least two selected therefrom. Wherein, typical but non-limiting combinations are: the adduct of 9,10-dihydro-9-oxa-10-phosphaphenanthrene-10-oxide and benzoquinone and the adduct of 9,10-dihydro-9-oxa-10-phosphaphenanthrene-10-oxide and 1,4-naphthoquinone, the adduct of 9,10-dihydro-9-oxa-10-phosphaphenanthrene-10-oxide and benzoquinone and the adduct of 9,10-dihydro-9-oxa-10-phosphaphenanthrene-10-oxide and *p*-hydroxyphenyl maleimide.

The structural formula of the adduct of 9,10-dihydro-9-oxa-10-phosphaphenanthrene-10-oxide and benzoquinone, *i*.*e*. DOPO-HQ, is as follows:

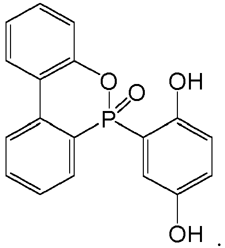

The structural formula of the adduct of 9,10-dihydro-9-oxa-10-phosphaphenanthrene-10-oxide and 1,4-naphthoquinone, *i.e.* DOPO-NQ, is as follows:

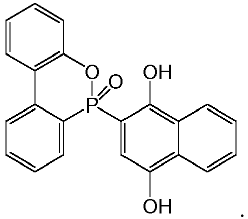

The structural formula of the adduct of 9,10-dihydro-9-oxa-10-phosphaphenanthrene-10-oxide and *p*-hydroxyphenyl maleimide, *i*.*e*. DOPO-HPM, is as follows:

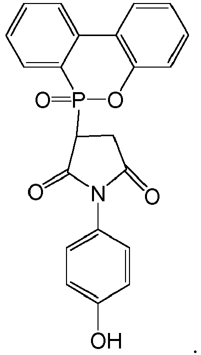

The structural formula of the adduct of 9,10-dihydro-9-oxa-10-phosphaphenanthrene-10-oxide and rosolic acid, *i*.*e*. DOPO-triol, is as follows:

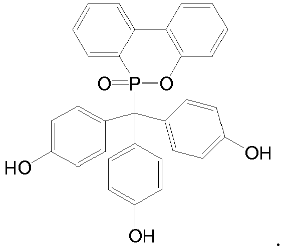

In addition to the phosphorus-containing phenolic compounds described above, other types of phosphorus-containing phenolic compounds may be included within the present invention, which are not particularly limited herein.

In the present invention, based on 100 parts by weight of the raw material of polyphenylene ether, the initiator is used in an amount of 4 to 30 parts, for example, 4 parts, 5 parts, 6 parts, 8 parts, 10 parts, 12 parts, 15 parts, 18 parts, 20 parts, 25 parts, 26 parts, 28 parts or 30 parts, as well as specific point values between the above values. The specific point values included within the range are no longer listed exhaustively herein due to the limitation of space and for concise considerations.

Preferably, the initiator is any one selected from the group consisting of dicumyl peroxide, *t*-butylcumyl peroxide, di-*t*-butyl peroxide, *t*-butyl peroxyisopropyl carbonate, 2,5-dimethyl-2,5-di-*t*-butylcumylperoxyhexyne-3, 2,5-dimethyl-2,5-di-*tert*-butylperoxy hexane, *p*-menthane hydroperoxide, 1,1-bis(*t*-amylperoxy)cyclohexane, hydrogen peroxide diisopropyl benzene, benzoyl peroxide, benzoyl peroxide derivative, and a combination of two or more selected therefrom. Wherein, typical but non-limiting combinations are: dicumyl peroxide and *t*-butylcumyl peroxide, di-*t*-butyl peroxide and *t*-butyl peroxyisopropyl carbonate, *t*-butyl peroxyisopropyl carbonate and 2,5-dimethyl-2,5-di-*t*-butylcumylperoxyhexyne-3, 2,5-dimethyl-2,5-di-*tert*-butylperoxyhexane.

A catalyst can be further used in the redistribution reaction for preparing the phosphorus-containing polyphenylene ether resin according to the present invention to promote the efficiency of the initiator.

Preferably, the catalyst is any one selected from the group consisting of a metal naphthenate, vanadium pentoxide, aniline, an amine compound, a quaternary ammonium salt, imidazole, a phosphonium salt, *etc*., and a combination of at least two selected therefrom. Wherein, typical but non-limiting combinations are: a metal naphthenate and vanadium pentoxide, vanadium pentoxide and aniline.

According to the present invention, based on the total amount of (A), (B), (C) and (D), the weight percentage of the epoxy resin composition is 10% to 50%, for example 10%, 12%, 15%, 18%, 20%, 25%, 28%, 30%, 32%, 35%, 38%, 40%, 42%, 44%, 45%, 48% or 50%, as well as specific point values between the above values. The specific point values included within the range are no longer listed exhaustively herein due to the limitation of space and for concise considerations.

In the present invention, the epoxy resin composition can be any one selected from the group consisting of bisphenol A epoxy resin, bisphenol F epoxy resin, bisphenol S epoxy resin, an epoxy resin containing a structure of dicyclopentadiene, benzene, naphthalene, fluorene, biphenyl, alicyclic, cresol novolac, isocyanate or hydantoin, and a combination of at least two selected therefrom. Wherein, typical but non-limiting combinations are: bisphenol A epoxy resin and bisphenol F epoxy resin, bisphenol S epoxy resin and an epoxy resin containing dicyclopentadiene.

According to the present invention, based on the total amount of (A), (B), (C) and (D), the weight percentage of the cyanate ester is 10% to 50%, for example 10%, 12%, 15%, 18%, 20%, 25%, 28%, 30%, 32%, 35%, 38%, 40%, 42%, 44%, 45%, 48% or 50%, as well as specific point values between the above values. The specific point values included within the range are no longer listed exhaustively herein due to the limitation of space and for concise considerations.

In the present invention, the cyanate ester resin can be any one selected from the group consisting of aromatic cyanate ester compounds of 2,2-bis(4-cyanatophenyl)propane, bis(3,5-dimethyl-4-cyanatophenyl)methane, 2,2-bis(4-cyanatophenyl)ethane or derivatives thereof, and a combination of at least two selected therefrom. Wherein, typical but non-limiting combinations are: 2,2-bis(4-cyanatophenyl)propane and bis(3,5-dimethyl-4-cyanatophenyl)methane, bis(3,5-dimethyl-4-cyanatophenyl)methane and 2,2-bis(4-cyanatophenyl)ethane.

According to the present invention, based on the total amount of (A), (B), (C) and (D), the weight percentage of the soluble halogen flame retardant is 10% to 30%, for example 10%, 12%, 15%, 18%, 20%, 25%, 28% or 30%, as well as specific point values between the above values. The specific point values included within the range are no longer listed exhaustively herein due to the limitation of space and for concise considerations.

In the present invention, the soluble halogen flame retardant refers to a class of halogen flame retardant that has a solubility in butanone of greater than 30 g/100 g of butanone, and a solubility in toluene of greater than 10 g/100 g of toluene.

In the present invention, the use of a soluble halogen flame retardant can further enhance the uniformity of the resin system. The laminate has good uniformity, enhanced adhesiveness and lower dielectric constant and dielectric loss, and thus the comprehensive properties of the laminate are improved.

In the present invention, the soluble halogen flame retardant can be any one selected from the group consisting of brominated polycarbonate, brominated polystyrene, polybrominated styrene, polybrominated acrylate, and a combination of at least two selected therefrom. Wherein, typical but non-limiting combinations are: polycarbonate and brominated polystyrene, brominated polystyrene and polybrominated styrene.

The resin composition of the present invention may further comprise an accelerant that is capable of catalyzing the reaction of the epoxy group with the cyanate ester or polyphenylene ether.

According to the present invention, the accelerant can be any one selected from the group consisting of 2-methyl imidazole, 2-phenyl imidazole, 2-ethyl-4-methyl imidazole, tri-n-butylamine, triphenylphosphine, quaternary phosphonium compound, thiourea and derivatives thereof, boron trifluoride complex, metal octoate, metal acetylacetonate, metal naphthenate, metal salicylate, metal stearate, and a combination of at least two selected therefrom; wherein the metal is any one selected from the group consisting of zinc, copper, iron, tin, cobalt, aluminum, and a combination of at least two selected therefrom.

The resin composition of the present invention may further comprise a filler which, in particular, can be any one selected from the group consisting of silica, boron nitride, aluminum hydroxide, boehmite, talc, clay, mica, kaolin, barium sulfate, calcium carbonate, magnesium hydroxide, zinc borate, and a combination of at least two selected therefrom. Based on 100 parts by weight of organic solids, the filler is added in an amount of 1 to 40 parts by weight.

The term "comprise", "comprises" or "comprising" as used in the present invention means that in addition to the described components, it may include other components that can confer different characteristics to the resin composition. In addition, "comprise", "comprises" or "comprising" described in the present invention may also be replaced by "are", "is" or "consisting of' in a closed form.

For example, the resin composition may further comprise various additives or adjuvants. A silane coupling agent, a filler dispersant, an antifoaming agent, an antioxidant, a heat stabilizer, an antistatic agent, an UV absorbent, a pigment, a colorant or a lubricant, *etc*., can be illustrated as specific examples. These additives or adjuvants may be used alone or in combination of two or more.

The preparation method of the resin composition of the present invention is a conventional technical approach in the art, which is: adding firstly the solid matters then the liquid solvent, stirring until the solid matters are completely dissolved, then adding the liquid resin and the accelerant, and stirring evenly.

The solvent in the present invention is not particularly limited, and specific examples thereof include alcohols such as methanol, ethanol and butanol; ethers such as ethyl cellosolve, butyl cellosolve, ethylene glycol methyl ether, carbitol and butyl carbitol; ketones such as acetone, butanone, methyl ethyl ketone, cyclohexanone; aromatic hydrocarbons such as toluene and xylene; esters such as ethyl acetate and ethoxyethyl acetate; nitrogen-containing solvents such as N,N-dimethylformamide and N,N-dimethylacetamide. The above solvents may be used alone or in combination of two or more. Ketones such as acetone, butanone, methyl ethyl ketone and cyclohexanone are preferred. The addition amount of the solvent is selected by those skilled in the art based on their own experience, as long as the resin glue can reach a viscosity suitable for use.

The present invention provides a resin glue obtained by dissolving or dispersing the resin composition as described above in a solvent.

The present invention also provides a prepreg obtained by impregnating a substrate material with the resin glue as described above and drying it.

The prepreg of the present invention comprises a reinforcing material and the resin composition as described above which has been adhered on the reinforcing material after impregnating and drying. The reinforcing material used is not particularly limited and may be an organic fiber, an inorganic fiber woven cloth or a non-woven fabric. The organic fiber may be selected from aramid non-woven fabric, and the inorganic fiber woven fabric may be E-glass fiber, D-glass fiber, S-glass fiber, T-glass fiber, NE-glass fiber or quartz fabric. The thickness of the reinforcing material is not particularly limited. In view of good dimensional stability of the laminate, the woven fabric and the non-woven fabric preferably have a thickness of 0.01 to 0.2 mm, and are preferably subjected to a fiber opening treatment and a surface treatment with a silane coupling agent. In order to provide good water resistance and heat resistance, the silane coupling agent is preferably any one selected from the group consisting of an epoxy silane coupling agent, an aminosilane coupling agent, a vinylsilane coupling agent, and a combination of at least two selected therefrom. The reinforcing material is impregnated with the resin composition described above and baked at 100-250 °C for 1-15 minutes to obtain the prepreg.

The copper clad laminate for a printed circuit board of the present invention comprises a laminate that is obtained by adhering two or more prepregs together by heating and pressuring and copper foil(s) that is(are) adhered to one or more sides of the laminate. The copper clad laminate is a double-sided copper clad laminate that is laminated by stacking 8 prepregs described above and two copper foils of one ounce (a thickness of 35 µm) together, and laminating in a thermocompressor. The lamination for the copper clad laminate is required to meet the following requirements: 1. Heating rate during lamination: when the material temperature is 80-160 °C, the heating rate during lamination generally should be controlled at 1.0-3.0 °C/min; 2. Pressure setting during lamination: a full pressure is applied when the temperature of the outer material is 80-100 °C, wherein the full pressure is about 300 psi; 3. During curing, the material temperature is controlled at 185 °C for 90 min. In addition to the copper foil, the material of the clad metal foil is not limited and may be a nickel foil, an aluminum foil and a SUS foil, *etc.*

Compared with the prior art, the present invention has at least the following beneficial effects:
In the present invention, by using a phosphorus-containing polyphenylene ether resin with a low molecular weight in combination with an epoxy resin and a cyanate ester, *etc.,* the compatibility of the system is improved, the phase separation region thereof is reduced and the size of the maximum phase separation "sea-island" is measured to be below 5 µm. The adhesion force and toughness of the laminate are enhanced. The use of the soluble halogen flame retardant further enhances the uniformity of the resin system. The laminate has good uniformity, enhanced adhesiveness and lower dielectric constant and dielectric loss. The dielectric constant can be controlled between 3.6 and 3.8 and the dielectric loss tangent can be controlled between 0.006 and 0.008, which improves the dielectric properties of the laminate.

### Detailed Description

In order to facilitate an understanding of the present invention, the following examples are illustrated in the present invention. It should be apparent to those skilled in the art that the illustrated examples are just for the purpose of facilitating the understanding of the present invention and should not be construed as particular limitations to the present invention.

The technical solutions of the present invention will be further described below by way of specific embodiments.

The followings are specific embodiments of the examples of the present invention. It should be noted that those skilled in the art can make some improvements and refinements without departing from the principles of the examples of the present invention. Such improvements and refinements are also considered within the scope of protection of the examples of the present invention.

The examples of the present invention are further described below in various examples. The examples of the present invention are not limited to the specific examples below. Appropriate modifications may be made without departing from the scope of the claims for implementation.

Unless otherwise stated, the "part(s)" represents "part(s) by weight", and the "%" represents "% by weight".

### Preparation Examples 1-7 and Comparative Preparation Example 1

100 parts of polyphenylene ether powder, 200 parts of toluene and a specific part of phosphorus-containing phenolic compound (see Table 1 for the types and parts) were added to a reaction kettle equipped with stirring, heating and reflux apparatuses, stirred and heated to 95 °C and stirred at this temperature until completely dissolved. A specific part of peroxide was divided into ten portions, which were then sequentially added into the reaction kettle. The temperature was kept for 8 hours to obtain a solution of low molecular weight-modified polyphenylene ether resin in toluene. The formulations thereof are shown in Table 1.

The above toluene solution was concentrated in a rotary evaporator, and then added dropwise to methanol, and filtered to obtain a precipitate. The precipitate was dried in a blast oven at 100 °C to obtain a low molecular weight-modified polyphenylene ether resin. The resin was measured for number average molecular weight (Mn) by using toluene as a mobile phase. Results are shown in Table 1.

**Table 1**

| | Preparation Example 1 | Preparation Example 2 | Preparation Example 3 | Preparation Example 4 | Preparation Example 5 | Preparation Example 6 | Preparation Example 7 | Comparative Preparation Example 1 |
|---|---|---|---|---|---|---|---|---|
| Polyphenylene ether SABIC Chemistry PPO 640 with a Mn of about 22000 | 100 | 100 | 100 | | | 100 | 100 | 100 |
| Polyphenylene ether Asahi Kasei S202A with a Mn of about 18000 | | | | 100 | | | | |
| Polyphenylene ether SABIC chemistry SA120 with a Mn of about 2500 | | | | | 100 | | | |
| Toluene | 200 | 200 | 200 | 200 | 200 | 200 | 200 | 200 |
| DOPO-HQ | 13 | 9.5 | | 13 | 9.5 | | 13 | |
| DOPO-HPM | | | 15 | | | | | |
| DOPO-triol | | | | | | 40 | | |
| Bisphenol A | | | | | | | | 8 |
| Benzoyl peroxide ARKEMA LUPROX A75C | 11 | 8 | 11 | 11 | 11 | 24 | | 11 |
| 1,1-bis(tert-amylperoxy)cyclohexane ARKEMA LUPROX 531 | | | | | | | 15 | |
| Cobalt naphthenate | | | | | | | 0.007 | |
| Number average molecular weight (Mn) of the low molecular weight-modified Polyphenylene ether | 2900 | 3300 | 3050 | 3000 | 1700 | 3300 | 3100 | 2700 |

### Examples 1-8 and Comparative Examples 1-9

The prepared modified polyphenylene ether in certain preparation example, an epoxy resin, a cyanate ester resin and a soluble halogen flame retardant were sufficiently dissolved in toluene, and then uniformly mixed with an insoluble halogen flame retardant, a filler and accelerants including 2-ethyl-4-methyl imidazole and zinc isooctanoate (see Tables 2 and 3 for the types and parts) to obtain a solution of polyphenylene ether resin composition in toluene.

A NE-type glass fiber (Nittobo Co., Ltd., NEA2116) was impregnated with this resin composition and dried at 155 °C for 2 to 10 minutes to remove the solvent to make the volatile content less than 1%. The gel time of the resin is 150 to 200 s. A prepreg having a resin content of about 55% was obtained.

A reversed copper foil of HOz was coated on both sides of four overlapped prepregs and subjected to hot pressing at a temperature of 200 °C and a pressure of 3.0 MPa for 90 min to obtain a double-sided copper clad laminate.

**Table 2**

| | Example 1 | Example 2 | Example 3 | Example 4 | Example 5 | Example 6 | Example 7 | Example 8 |
|---|---|---|---|---|---|---|---|---|
| Modified polyphenylene ether | Preparation Example 1 | Preparation Example 3 | Preparation Example 5 | Preparation Example 1 | Preparation Example 1 | Preparation Example 2 | Preparation Example 3 | Preparation Example 1 |
| | 50 | 50 | 50 | 25 | 50 | 20 | 70 | 50 |
| Low-molecular-weight polyphenylene ether SA120 | | | | | | | | |
| Low-molecular-weight polyphenylene ether SA90 with a Mn of about 1800 | | | | 25 | | | | |
| Epoxy resin NC3000H | | 25 | | | | 80 | 25 | |
| Epoxy resin NC3000L | 50 | | 50 | 50 | 50 | | | 50 |
| Epoxy resin HP-7200H | 17 | 55 | 17 | 17 | 30 | | | 17 |
| Cyanate ester resin CE01PS | 50 | 50 | 50 | 50 | 37 | 60 | 70 | 50 |
| Brominated polycarbonate BC-58 | 65 | 65 | | | | | 65 | 65 |
| Brominated polystyrene SAYTEX HP-3010 | | | 55 | 55 | 55 | 55 | | |
| Ethylene bis-tetrabromophthalimide SAYTEX®BT-93W | | | | | | | | |
| 2E4MI | 0.1 | 0.1 | 0.1 | 0.1 | 0.5 | 0.5 | 0.1 | 0.1 |
| Zinc isooctanoate Bicat Z | 0.1 | 0.1 | 0.1 | 0.1 | 0.05 | 0.1 | 0.1 | 0.1 |
| Toluene | 120 | 115 | 120 | 120 | 130 | 120 | 120 | 170 |
| Molten silica FS1002 | | | | | | | | 100 |
| Laminate properties | | | | | | | | |
| Dk@10GHz | 3.6 | 3.7 | 3.7 | 3.8 | 3.8 | 3.9 | 3.6 | 3.9 |
| Df@10GHz | 0.006 | 0.007 | 0.007 | 0.007 | 0.007 | 0.009 | 0.006 | 0.006 |
| Tg/°C | 200 | 190 | 180 | 180 | 170 | 170 | 180 | 200 |
| Td/°C | 380 | 380 | 380 | 380 | 375 | 380 | 380 | 392 |
| PS | 1.0 | 1.1 | 1.0 | 1.0 | 1.1 | 1.2 | 0.9 | 0.9 |
| Drop hammer impact/mm² | 500 | 550 | 490 | 520 | 560 | 470 | 480 | 480 |
| Size of the maximum phase separation "sea-island" | <5µm | <5µm | <5µm | <5µm | <5µm | 0µm | <10µm | <5µm |
| Flame retardancy | V-0 | V-0 | V-0 | V-0 | V-0 | V-0 | V-0 | V-0 |

**Table 3**

| | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|
| Modified polyphenylene ether | Preparation Example 1 | Comparative Preparation Example 1 | Comparative Preparation Example 1 | | | Preparation Example 1 | Preparation Example 1 | Preparation Example 1 | Preparation Example 1 |
| | 50 | 50 | 50 | | | 150 | 10 | 70 | 70 |
| Low-molecular -weight polyphenylene ether SA120 | | | | 50 | | | | | |
| Low-molecular-weight polyphenylene ether SA90 | | | | | 50 | | | | |
| Epoxy resin NC3000H | | | | | | | | 35 | 25 |
| Epoxy resin NC3000L | 50 | 50 | 50 | 50 | 50 | 50 | 50 | | |
| Epoxy resin HP-7200H | 17 | 17 | 17 | 17 | 17 | 17 | 35 | 60 | |
| Cyanate ester resin CE01PS | 50 | 50 | 50 | 50 | 50 | 50 | 70 | | |
| Brominated polycarbonate BC-58 | | | 65 | | | 65 | | 65 | 65 |
| Brominated polystyrene SAYTEX HP-3010 | | 55 | | 55 | 55 | | 55 | | |
| Ethylene bis-tetrabromophthalimide SAYTEX®BT-93W | 65 | | | | | | | | |
| 2E4MI | 0.1 | 0.1 | 0.1 | 0.1 | 0.1 | 0.1 | 0.5 | 2 | 0.1 |
| Zinc isooctanoate Bicat Z | 0.1 | 0.1 | 0.1 | 0.1 | 0.05 | 0.1 | 0.1 | | 0.1 |
| Toluene | 120 | 120 | 120 | 120 | 120 | 200 | 120 | 120 | 120 |
| Laminate properties | | | | | | | | | |
| Dk@10GHz | 3.9 | 4.0 | 3.8 | 4.1 | 4.2 | 3.6 | 4.2 | 4.0 | The laminate is fragile and cannot be tested. |
| Df@10GHz | 0.009 | 0.009 | 0.009 | 0.010 | 0.012 | 0.008 | 0.010 | 0.011 | |
| Tg/°C | 190 | 190 | 180 | 195 | 135 | 150 | 200 | 145 | |
| Td/°C | 380 | 350 | 355 | 350 | 340 | 360 | 340 | 330 | |
| PS | 0.4 | 0.5 | 0.6 | 0.4 | 0.7 | 0.2 | 0.6 | 0.9 | |
| Drop hammer impact/mm² | 650 | 800 | 700 | 980 | 600 | 2000 | 600 | 700 | |
| Size of the maximum phase separation "sea-island" | 20µm | 30µm | 20µm | >50µm | 5µm | >50µm | 5µm | >50µm | |
| Flame retardancy | V-0 | V-0 | V-0 | V-0 | V-0 | V-0 | V-0 | V-0 | |

The above characteristics were determined through the following methods:
1) Volatility: The prepared prepreg was baked at 155 °C for 10 min, followed by measurement of the mass loss of the prepreg. A loss of more than 2% indicates volatilization;
2) Gel time: Determined by using a gel tester at a temperature of 171 °C;
3) Dielectric constant (Dk) and dielectric dissipation factor (Df): Determined by using a split post dielectric resonator (SPDR);
4) Glass transition temperature (Tg): Determined by using a dynamic mechanical analysis (DMA) test with a heating rate of 20 °C/min;
5) Thermal decomposition temperature (Td): Determined by using a thermogravimetric analyzer (TGA) with a heating rate of 10 °C/min. The temperature at which point 5% weight loss occurred was collected;
6) Peel strength (PS): refers to the pulling force required to peel off a millimetre of copper foil from the copper clad laminate at room temperature;
7) Flame retardancy: Determined according to UL94 "50W (20 mm) Vertical Burning Test: V-0, V-1 and V-2", and V-0 is considered as being flame retardant;
8) Drop hammer impact: Determined by using a paint film impactor, and the crack area after the impact was collected.
9) Size of the maximum phase separation "sea-island": The cross section of the laminate was observed by using scanning electron microscopy (SEM), and the diameter of the maximum phase separation region "sea-island" was collected;
10) Number average molecular weight (Mn) of the low molecular weight-modified polyphenylene ether: The modified polyphenylene ethers obtained by the preparation examples were tested by GPC. The number average molecular weight (Mn) at the main peak of the GPC spectrum was collected. Toluene was used as mobile phase.

It can be seen from the above results that the number average molecular weights of the low molecular weight-modified polyphenylene ethers of Preparation Examples 1-7, in which a phosphorus-containing phenolic compound was used, were not much different from that of Comparative Preparation Example 1, and products with various Mn can be obtained by adjusting the ratio of the phenolic compound.

The sizes of the maximum phase separation "sea-island" of the resin compositions obtained in Examples 1-8 by using the phosphorus-containing polyphenylene ether resin with a low molecular weight of the present invention were shown to be less than 5 µm, thereby illustrating that the polyphenylene ether resin of the present invention had good compatibility with other resins. The resin composition of Example 8, into which molten silica was added as a filler, had an increased Dk relative to Example 1, but the comprehensive properties were superior. However, the size of the maximum phase separation "sea-island" of the resin composition obtained in Comparative Example 1 without using a soluble halogen flame retardant was shown to reach 20 µm, which was much larger than the "sea-island" size of Example 1. The sizes of the maximum phase-separation "sea-island" were shown to be 20-30 µm in Comparative Examples 2-3 in which a soluble halogen flame retardant was used and the polyphenylene ether resin of the present invention was not used. Moreover, the drop hammer impact areas thereof were larger than those of Examples 3 and 1, respectively, that is, the impact resistance was obviously poor. The size of the maximum phase separation "sea-island" of the resin composition obtained in Comparative Example 4 by using low-molecular-weight polyphenylene ether SA120 was shown to reach at least 50 µm, which was larger than the size of the "sea-island" of Example 3 in which the polyphenylene ether resin of the present invention was used, thereby illustrating that the resin composition obtained in Comparative Example 4 had poor compatibility with other resins. The size of the maximum phase separation "sea-island" of the resin composition obtained in Comparative Example 5 by using low-molecular-weight polyphenylene ether SA90 was smaller and shown to be 5 µm. However, the resin composition obtained in Comparative Example 5 had an extremely low glass transition temperature and higher dielectric constant and dielectric loss compared to that of Example 3. The size of the maximum phase separation "sea-island" was shown to reach at least 50 µm and the peel strength was too low in Comparative Example 6, in which an excessive amount of phosphorus-containing polyphenylene ether resin with a low molecular weight was used. The corresponding "sea-island" size was small, but the dielectric properties were significantly poor in Comparative Example 7, in which too little phosphorus-containing polyphenylene ether resin with a low molecular weight was used. The glass transition temperature of the laminate was significantly lower and the size of "sea-island" was too larger in Comparative Example 8, in which cyanate ester was not used. The laminate prepared in Comparative Example 9, in which cyanate ester was not used and the epoxy resin content was lower, was fragile and cannot be tested.

In addition, it can be seen from Examples 1-8 that the Dk values of the resulting laminates were 3.6-3.8, and the Df values were between 0.006 and 0.008, which were significantly lower than the Dk values (3.9-4.2) and the Df values (0.009-0.012) in Comparative Examples 1-5 and 7-8, indicating that the dielectric properties thereof were better than those of Comparative Examples 1-5 and 7-8. Although the Dk and Df of Comparative Example 6 were lower, other properties were poor and thus cannot meet the application.

The above results show that the use of the resin composition obtained in the present invention in copper clad laminates effectively improves the dielectric properties of the laminate, enhances the peel strength, impact resistance and thermal decomposition temperature Td of the laminates, significantly improves the phase separation "sea-island" phenomenon of the resin system and maintains the heat resistance properties such as glass transition temperature Tg of the laminate.

Based on the above, those skilled in the art can make other kinds of corresponding changes and modifications according to the technical solutions and technical ideas of the present invention. All such changes and modifications are within the scope of protection of the claims of the present invention.

The applicant states that detailed compositions of the present invention are demonstrated in the present invention through the above embodiments. However, the present invention is not limited to the above detailed compositions, and it does not mean that the present invention must rely on the above detailed compositions to implement. It should be apparent to those skilled in the art that, for any improvement of the present invention, the equivalent replacement of the raw materials of the present invention, the addition of auxiliary components, and the selection of specific modes, *etc*., will all fall within the protection scope and the disclosure scope of the present invention.

## Claims

1. A resin composition, comprising, by weight percentage:
(A) 10% to 45% of a phosphorus-containing polyphenylene ether resin having a number average molecular weight of 1000 to 6000;
(B) 10% to 50% of an epoxy resin composition;
(C) 10% to 50% of a cyanate ester resin;
(D) 10% to 30% of a soluble halogen flame retardant.

2. The resin composition according to claim 1, wherein the phosphorus-containing polyphenylene ether resin is synthesized from a phosphorus-containing phenolic compound and a polyphenylene ether;
preferably, the phosphorus-containing polyphenylene ether resin is a phosphorus-containing polyphenylene ether resin having a number average molecular weight of 1000 to 6000 which is obtained by subjecting a raw material of polyphenylene ether having a number average molecular weight of 2000-40000 and a phosphorus-containing phenolic compound which is suspended in the solution of the polyphenylene ether to a redistribution reaction in the presence of an initiator.

3. The resin composition according to claim 2, wherein based on 100 parts by weight of the raw material of polyphenylene ether, the phosphorus-containing phenolic compound is used in an amount of 4 to 50 parts;
preferably, the phosphorus-containing phenolic compound is a derivative of 9,10-dihydro-9-oxa-10-phosphaphenanthrene-10-oxide containing one or more phenolic hydroxyl groups; preferably contains any one selected from the group consisting of the adducts of 9,10-dihydro-9-oxa-10-phosphaphenanthrene-10-oxide and, respectively, benzoquinone, 1,4-naphthoquinone, *p*-hydroxyphenyl maleimide and rosolic acid, and a combination of at least two selected therefrom;
preferably, the structural formula of the adduct of 9,10-dihydro-9-oxa-10-phosphaphenanthrene-10-oxide and benzoquinone is as follows: 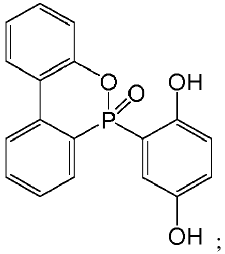 preferably, the structural formula of the adduct of 9,10-dihydro-9-oxa-10-phosphaphenanthrene-10-oxide and 1,4-naphthoquinone is as follows: 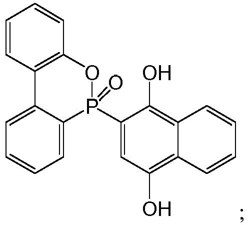 preferably, the structural formula of the adduct of 9,10-dihydro-9-oxa-10-phosphaphenanthrene-10-oxide and *p*-hydroxyphenyl maleimide is as follows: 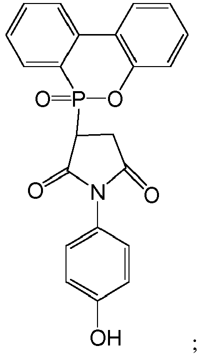 preferably, the structural formula of the adduct of 9,10-dihydro-9-oxa-10-phosphaphenanthrene-10-oxide and rosolic acid is as follows:

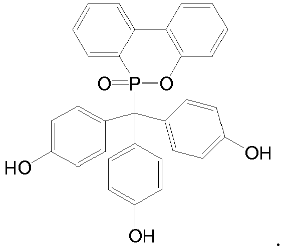

4. The resin composition according to claim 2 or 3, wherein based on 100 parts by weight of the raw material of polyphenylene ether, the initiator is used in an amount of 4 to 30 parts;
preferably, the initiator is any one selected from the group consisting of dicumyl peroxide, *t*-butylcumyl peroxide, di-*t*-butyl peroxide, *t*-butyl peroxyisopropyl carbonate, 2,5-dimethyl-2,5-di-t-butylcumylperoxyhexyne-3, 2,5-dimethyl-2,5-di-tert-butylperoxy hexane, *p*-menthane hydroperoxide, 1,1-bis(*t*-amylperoxy)cyclohexane, hydrogen peroxide diisopropyl benzene, benzoyl peroxide, benzoyl peroxide derivative, and a combination of two or more selected therefrom;
preferably, a catalyst is used in the redistribution reaction for preparing the phosphorus-containing polyphenylene ether resin;
preferably, the catalyst is any one selected from the group consisting of a metal naphthenate, vanadium pentoxide, aniline, an amine compound, a quaternary ammonium salt, imidazole, a phosphonium salt, *etc*., and a combination of at least two selected therefrom.

5. The resin composition according to any one of claims 1-4, wherein the epoxy resin composition is any one selected from the group consisting of bisphenol A epoxy resin, bisphenol F epoxy resin, bisphenol S epoxy resin, an epoxy resin containing a structure of dicyclopentadiene, benzene, naphthalene, fluorene, biphenyl, alicyclic, cresol novolac, isocyanate or hydantoin, and a combination of at least two selected therefrom;
preferably, the cyanate ester resin is any one selected from the group consisting of aromatic cyanate ester compounds of 2,2-bis(4-cyanatophenyl)propane, bis(3,5-dimethyl-4-cyanatophenyl)methane, 2,2-bis(4-cyanatophenyl)ethane or derivatives thereof, and a combination of at least two selected therefrom;
preferably, the soluble halogen flame retardant has a solubility in butanone of greater than 30 g/100 g of butanone, and a solubility in toluene of greater than 10 g/100 g of toluene; preferably is any one selected from the group consisting of brominated polycarbonate, brominated polystyrene, polybrominated styrene, polybrominated acrylate, and a combination of at least two selected therefrom.

6. The resin composition according to any one of claims 1-5, wherein the resin composition further comprises an accelerant;
preferably, the accelerant is any one selected from the group consisting of 2-methyl imidazole, 2-phenyl imidazole, 2-ethyl-4-methyl imidazole, tri-n-butylamine, triphenylphosphine, quaternary phosphonium compound, thiourea and derivatives thereof, boron trifluoride complex, metal octoate, metal acetylacetonate, metal naphthenate, metal salicylate, metal stearate, and a combination of at least two selected therefrom; wherein the metal is any one selected from the group consisting of zinc, copper, iron, tin, cobalt, aluminum, and a combination of at least two selected therefrom;
preferably, the resin composition further comprises a filler;
preferably, the filler is any one selected from the group consisting of silica, boron nitride, aluminum hydroxide, boehmite, talc, clay, mica, kaolin, barium sulfate, calcium carbonate, magnesium hydroxide, zinc borate, and a combination of at least two selected therefrom.

7. A resin glue obtained by dissolving or dispersing the resin composition according to any one of claims 1-6 in a solvent.

8. A prepreg obtained by impregnating a substrate material with the resin glue according to claim 7 and drying it.

9. A laminate obtained by lamination molding at least one prepreg according to claim 8.

10. A printed circuit board comprising at least one laminate according to claim 9.
